# EUROPÄISCHE PATENTSCHRIFT

(11) **EP 3 143 696 B1**
(45) Veröffentlichungstag und Bekanntmachung des Hinweises auf die Patenterteilung: **29.03.2023**
(21) Anmeldenummer: 15718777.4
(22) Anmeldetag: 23.04.2015
(51) Int. Cl.: H03K 17/968, H03K 17/969

(54) **BEDIENVORRICHTUNG, INSBESONDERE FÜR EIN ELEKTRONISCHES HAUSHALTSGERÄT**
OPERATING DEVICE, IN PARTICULAR FOR AN ELECTRONIC HOUSEHOLD APPLIANCE
DISPOSITIF DE COMMANDE, NOTAMMENT POUR UN APPAREIL ÉLECTROMÉNAGER

(30) Priorität: 13.05.2014 DE 102014007036
(43) Veröffentlichungstag der Anmeldung: 22.03.2017
(73) Patentinhaber: Diehl AKO Stiftung & Co. KG, 88239 Wangen (DE)
(72) Erfinder: MAIGLER, Andreas, 88339 Bad Waldsee (DE); FUHGE, Bruno, 88147 Achberg (DE); LYSZUS, Joachim, 88255 Baindt (DE); STOHR, Ralph, 88299 Leutkirch (DE); FROMMELT, Thomas, 81243 München (DE)
(74) Vertreter: Diehl Patentabteilung
(86) Internationale Anmeldenummer: PCT/EP2015/000846
(87) Internationale Veröffentlichungsnummer: WO 2015/172863

(56) Entgegenhaltungen:
- DE-A1-102012 203 005
- DE-U1-202006 014 856
- US-A1- 2007 109 152
- US-A1- 2010 302 196

## Beschreibung

Die vorliegende Erfindung betrifft eine Bedienvorrichtung, insbesondere eine Bedienvorrichtung für elektronische Haushaltsgeräte.

Für Bedienvorrichtungen sind verschiedene Arten von Bedienelementen mit unterschiedlichen Funktionsweisen bekannt. Bei den als Drucktasten ausgebildeten Bedienelementen kann man zum Beispiel zwischen berührungs- und/oder annäherungsempfindlichen Drucktasten (sog. "Touch Control") und durch Krafteinwirkung betätigbaren Drucktasten differenzieren, die jeweils mit verschiedenen Aufbauten und Funktionsweisen realisierbar sind.

In diesem Zusammenhang sind bei den durch Krafteinwirkung betätigbaren Drucktasten neben solchen mit einem mechanischen Betätigungselement insbesondere auch kapazitive Drucktasten (vgl. z.B. DE 10 2011 121 897 A1), induktive Drucktasten (vgl. z.B. EP 2 529 484 B1) und piezoelektrische Drucktasten bekannt. Diese speziellen Drucktasten erfordern im Allgemeinen eine hohe Fertigungs- und Montagegenauigkeit mit kleinen Toleranzbereichen.

Berührungs- und annäherungsempfindliche Drucktasten besitzen häufig eine Sensorik, die auf einem kapazitiven oder induktiven Funktionsprinzip beruht. Im Fall von metallischen Bedienblenden müssen diese Drucktasten dann mit zusätzlichen Maßnahmen zur elektrischen Isolierung versehen werden. Andere berührungs- und/oder annäherungsempfindliche Drucktasten mit einer optischen Sensorik (vgl. z.B. DE 10 2006 004 979 B4) benötigen grundsätzlich eine Bedienblende aus einem transparenten Material oder mit Durchbrechungen.

Die US 2007/0109152 A1 offenbart eine Eingabevorrichtung für einen Computer in Form einer Tastatur, auf welcher der Oberbegriff des Anspruchs 1 basiert. Diese bekannte Bedienvorrichtung weist eine Vielzahl von bewegbaren Tasten auf, die jeweils mit einem nach innen ragenden Vorsprung versehen sind, wobei diese Vorsprünge die von einer gemeinsamen Lichtquelle ausgesendete Strahlung zu einem gemeinsamen Empfänger reflektieren. Dabei unterscheiden sich die Reflexionsrichtungen der einzelnen Vorsprünge und die Reflexionsrichtung eines Vorsprungs je nach gedrückter oder nicht gedrückter Taste, sodass der Empfänger mittels ortsauflösender Erfassung detektieren kann, welche der mehreren Tasten betätigt wird.

Die DE 10 2012 203 005 A1 offenbart einen Berührungssensor mit einem bei Berührung verformbaren Oberflächenelement. An einer Rückseite des Oberflächenelements wird von einem Beleuchtungsmittel ausgesendete Strahlung reflektiert und von einem Detektionselement erfasst. Mit Hilfe einer Auswerteeinrichtung erfolgt ein Auswerten von Veränderungen der von dem Detektionselement erfassten Strahlen aufgrund einer Verformung des Oberflächenelements.

Die DE 20 2006 014 856 U1 offenbart ein Haushaltsgerät mit einer licht-durchlässigen Platte und einem optisch arbeitenden Eingabeelement. Eine Lichtquelle und ein Lichtdetektor sind auf einer Rückseite der Platte angeordnet, und ein verformbares Bedienelement ist auf einer Vorderseite der Platte angeordnet. Das von der Lichtquelle ausgesendete Licht wird von der Rückseite des Bedienelements reflektiert, wobei eine Verformung des Bedienelements eine Änderung des vom Lichtdetektor empfangenen reflektierten Lichts bewirkt.

Die US 2010/0302196 A1 offenbart eine Touch-Screen-Vorrichtung mit einer durch Aufdrücken verformbaren Schicht, einem an einen Sender gekoppelten Lichtleiter und einem ortsauflösenden Bildsensor, der die je nach Betätigung des Touch-Screens durch den Lichtleiter an der verformten Schicht reflektierten Strahlungen erfasst, um den Betätigungsort zu ermitteln

Es ist die Aufgabe der vorliegenden Erfindung, eine Bedienvorrichtung mit mehreren durch Krafteinwirkung betätigbaren Drucktasten zu schaffen, welche eine zuverlässige Funktionsweise aufweist und einfach aufgebaut ist.

Diese Aufgabe wird gelöst durch eine Bedienvorrichtung mit den Merkmalen des Anspruchs 1. Besonders bevorzugte Ausgestaltungen und Weiterbildungen der Erfindung sind Gegenstand der abhängigen Ansprüche.

Die Bedienvorrichtung der Erfindung hat eine Abdeckplatte mit einer einem Benutzer zugewandten Benutzerseite, wobei die Abdeckplatte mehrere Bedienabschnitte zum Definieren mehrerer Bedienelemente aufweist, welche jeweils derart ausgestaltet sind, dass sie durch eine Krafteinwirkung von der Benutzerseite der Abdeckplatte her zumindest teilweise elastisch verformbar und/oder bewegbar sind; wenigstens einen Sender zum Emittieren von elektromagnetischer Strahlung und wenigstens einen Empfänger zum Erfassen von elektromagnetischer Strahlung, wobei die Bedienabschnitte jeweils derart ausgestaltet sind, dass sie die von dem wenigstens einen Sender emittierte Strahlung zumindest teilweise reflektieren, und der wenigstens eine Empfänger derart angeordnet und/oder ausgestaltet ist, dass er eine ortsaufgelöste Erfassung der von den Bedienabschnitten reflektierten Strahlung ermöglicht; und eine Steuerelektronik zum Auswerten von von dem wenigstens einen Empfänger erzeugten Messsignalen, die in Abhängigkeit von einem Erfassungsort der reflektierten Strahlung eine Betätigung der Bedienabschnitte detektiert. Die Bedienvorrichtung ist erfindungsgemäß ferner dadurch gekennzeichnet, dass für mehrere der mehreren Bedienabschnitte ein gemeinsamer Sender und jeweils ein eigener Empfänger vorgesehen sind oder ein gemeinsamer Empfänger und jeweils ein eigener Sender vorgesehen sind, wobei die mehreren eigenen Empfänger oder die mehreren eigenen Sender, die verschiedenen Bedienabschnitten zugeordnet sind, von der Steuerelektronik getaktet betrieben werden, um die Betätigungen der verschiedenen Bedienabschnitte voneinander zu differenzieren.

Bei der erfindungsgemäßen Bedienvorrichtung genügen minimale Verformungen bzw. Bewegungshübe der Bedienabschnitte, um eine Betätigung durch den Benutzer erfassen zu können, da bereits bei sehr kleinen Veränderungen des Reflexionsortes am Bedienabschnitt sehr unterschiedliche Ablenkungen der elektromagnetischen Strahlung bewirkt werden. Die Betätigung der Bedienabschnitte kann daher durch die Steuerelektronik sehr zuverlässig erkannt werden.

Zudem können bei einer derart konzipierten Bedienvorrichtung die Toleranzen bei der Fertigung und der Montage der Bauteile im Vergleich zu herkömmlichen, durch Krafteinwirkung betätigbaren Drucktasten mit kapazitiver, induktiver oder piezoelektrischer Funktionsweise größer sein. Dies wird durch den bereits bei minimalen Veränderungen des Reflexionsortes am Bedienabschnitt bewirkten, stark unterschiedlichen Erfassungsort am Empfänger erreicht. Auch dies kann die Fehleranfälligkeit reduzieren und so die Zuverlässigkeit der Bedienvorrichtung erhöhen.

Die Bedienvorrichtung der Erfindung ermöglicht eine nachträgliche Adaptierung der Steuerelektronik an die mechanischen Komponenten wie insbesondere die Abdeckplatte mit dem Bedienabschnitt.

Da es für das Detektieren einer Betätigung der Bedienabschnitte ausreicht, eine relative Veränderung des Erfassungsortes der reflektierten Strahlung am Empfänger zu erfassen (im Gegensatz zum Erfassen eines absoluten Wertes), kann bei der erfindungsgemäßen Bedienvorrichtung auch ein Kalibrierungsvorgang entfallen.

Die Abdeckplatte kann in diesem Zusammenhang aus einem beliebigen Material, mit beliebigen Dimensionierungen und mit einem beliebigen Design gefertigt sein. Bei der Abdeckplatte handelt es sich vorzugsweise um eine Bedienblende zum Beispiel eines elektronischen Haushaltsgerätes.

Die Bedienabschnitte sind vorzugsweise einstückig mit der Abdeckplatte ausgebildet, als separate Komponente in die Abdeckplatte eingesetzt oder als separate Komponente mit der Abdeckplatte verbunden. Die Bedienabschnitte definieren für den Benutzer die Bedienelemente der Bedienvorrichtung, die er/sie zum Betätigen drücken muss. Die Bedienabschnitte sind vorzugsweise für den Benutzer kenntlich gemacht, bevorzugt durch eine spezielle Formgebung seiner Benutzerseite (haptische Kennzeichnung), eine Kennzeichnung mit Farben und/oder Symbolen, eine Hinterleuchtung, eine erkennbare Abgrenzung zur übrigen Abdeckplatte und dergleichen.

Die Bedienabschnitte sind jeweils durch eine Krafteinwirkung von der Benutzerseite der Abdeckplatte her zumindest teilweise elastisch verformbar und/oder bewegbar. Die elastische Verformbarkeit wird vorzugsweise durch eine spezielle Materialauswahl und/oder eine spezielle Dimensionierung des Bedienabschnitts erzielt. Die elastische Bewegbarkeit kann vorzugsweise durch eine gefederte Lagerung des Bedienabschnitts in einer Durchbrechung in der Abdeckplatte realisiert werden.

Bei der elektromagnetischen Strahlung, die von dem wenigstens einen Sender emittiert und von dem wenigstens einen Empfänger erfasst wird, handelt es sich vorzugsweise um optische Strahlung, bevorzugt im sichtbaren oder Infrarot-Wellenlängenbereich. Der wenigstens eine Empfänger ist bezüglich der von ihm erfassbaren elektromagnetischen Strahlung auf die von dem wenigstens einen Sender emittierte elektromagnetische Strahlung abgestimmt, bevorzugt stimmen die jeweiligen Wellenlängenbereiche im Wesentlichen überein oder haben einen signifikanten Überlappungsbereich.

Bei dem wenigstens einen Sender handelt es sich vorzugsweise um eine Leuchtdiode (LED), eine Laserdiode, eine Glühlampe, eine Halogenlampe oder dergleichen. Der wenigstens eine Sender kann aber auch durch das Umgebungslicht realisiert werden, welches durch eine entsprechende Öffnung zum Beispiel im Gerätegehäuse oder in der Abdeckplatte auf die Rückseite des Bedienabschnitts gelangen kann.

Der wenigstens eine Empfänger ermöglicht eine ortsaufgelöste Erfassung der reflektierten Strahlung. Vorzugsweise ist der wenigstens eine Empfänger genau ein Empfänger mit einer ortsauflösenden Funktionsweise oder ist der wenigstens eine Empfänger durch mehrere Empfänger gebildet, die im Wesentlichen nebeneinander angeordnet sind. Der wenigstens eine Empfänger ist dementsprechend bevorzugt ausgewählt aus einem CCD-Chip, einem aktiven Pixelsensor, Photodioden, Phototransistoren, Umgebungslichtsensoren und dergleichen.

Die Bedienabschnitte sind jeweils so ausgestaltet, dass sie die von dem wenigstens einen Sender emittierte Strahlung zumindest teilweise reflektieren können. Diese Reflexionseigenschaft der Bedienabschnitte wird vorzugsweise erreicht durch eine spezielle Materialauswahl der Bedienabschnitte, durch eine spezielle Oberflächenstruktur der Rückseite der Bedienabschnitte, durch eine spezielle Oberflächenbehandlung (bevorzugt Beschichtung, etc.) der Rückseite der Bedienabschnitte oder dergleichen.

Die Bedienvorrichtung der Erfindung kann trotz ihrer optischen Funktionsweise in vorteilhafter Weise auch bei - für die jeweilige elektromagnetische Strahlung - im Wesentlichen undurchlässigen Abdeckplatten eingesetzt werden. Insbesondere können auch die Bedienabschnitte für die von dem wenigstens einen Sender emittierte Strahlung im Wesentlichen undurchlässig ausgestaltet sein.

Die Bedienvorrichtung kann neben den durch eine Krafteinwirkung betätigbaren und optisch auswertbaren Bedienabschnitten weitere Bedienelemente mit anderen Funktionsweisen aufweisen. Dabei können insbesondere andere Drucktasten und berührungs- und/oder annäherungsempfindliche Tasten zum Einsatz kommen.

Gemäß der Erfindung weist die Abdeckplatte mehrere Bedienabschnitte auf, die jeweils durch eine Krafteinwirkung von der Benutzerseite der Abdeckplatte her elastisch verformbar und/oder bewegbar ausgestaltet sind. Die Bedienvorrichtung weist somit mehrere durch einen Benutzer betätigbare Bedienelemente auf.

Dabei sind für mehrere (d.h. für wenigstens zwei oder sogar alle) der mehreren Bedienabschnitte ein gemeinsamer Sender und jeweils ein eigener Empfänger oder ein gemeinsamer Empfänger und jeweils ein eigener Sender vorgesehen.

In einer Ausgestaltung der Erfindung ist zudem wenigstens ein Lichtleiter vorgesehen, um die von dem wenigstens einen Sender emittierte Strahlung zu einem der mehreren Bedienabschnitte bzw. zu mehreren der mehreren Bedienabschnitte zu transportieren. Diese Ausgestaltung kann eine kompakte Bauweise im Bereich der Bedienabschnitte ermöglichen, da der wenigstens eine Sender an einer anderen Stelle platziert werden kann. Der wenigstens eine Lichtleiter kann die Strahlung vorzugsweise über mehrere Auskoppelstellen zu mehreren Bedienabschnitten transportieren.

Gemäß der Erfindung werden ferner die mehreren eigenen Empfänger, oder die mehreren eigenen Sender, die verschiedenen Bedienabschnitten zugeordnet sind, von der Steuerelektronik getaktet betrieben. Auf diese Weise können Betätigungen von verschiedenen Bedienabschnitten trotz gemeinsam genutzter Sender oder Empfänger voneinander differenziert werden.

In einer Ausgestaltung der Erfindung können mehrere der mehreren Bedienabschnitte wenigstens einen Reflektor zum Reflektieren der von dem wenigstens einen Sender emittierten Strahlung aufweisen, wobei die verschiedenen Bedienabschnitten zugeordneten Reflektoren unterschiedliche Reflexionswinkel haben. Bei dieser Ausgestaltung können Sender oder Empfänger in vorteilhafter Weise gemeinsam für mehrere Bedienabschnitte genutzt werden.

In einer Ausgestaltung der Erfindung kann wenigstens eine Linse angeordnet sein, die mehreren der mehreren Bedienabschnitte gemeinsam zugeordnet ist und die von verschiedenen Bedienabschnitten reflektierten Strahlungen unter-schiedlich ablenkt. Auch bei dieser Ausgestaltung können Sender oder Empfänger in vorteilhafter Weise gemeinsam für mehrere Bedienabschnitte genutzt werden.

Gegenstand der Erfindung ist außerdem ein elektronisches Haushaltsgerät mit wenigstens einer oben beschriebenen Bedienvorrichtung der Erfindung.

Bei dem elektronischen Haushaltsgerät handelt es sich vorzugsweise um ein Wäschebehandlungsgerät (Waschmaschine, Wäschetrockner, etc.), eine Spülmaschine, ein Kühl-und/oder Gefriergerät (Kühlschrank, Gefriertruhe, etc.), ein Kochfeld, einen Herd, einen Mikrowellenofen, einen Dunstabzug oder dergleichen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine stark vereinfachte Darstellung des Funktionsprinzips einer Bedienvorrichtung gemäß einer ersten Ausführungsvariante der Erfindung;
- Fig. 2: eine Schnittansicht einer Bedienvorrichtung mit mehreren Bedienabschnitten gemäß einem Ausführungsbeispiel der Erfindung;
- Fig. 3: eine Draufansicht einer Bedienvorrichtung mit mehreren Bedienabschnitten gemäß einem weiteren Ausführungsbeispiel der Erfindung;
- Fig. 4: eine Draufansicht einer Bedienvorrichtung mit mehreren Bedienabschnitten gemäß einem weiteren Ausführungsbeispiel der Erfindung;
- Fig. 5: eine Schnittansicht einer Bedienvorrichtung mit mehreren Bedienabschnitten gemäß einem noch weiteren Ausführungsbeispiel der Erfindung;
- Fig. 6: eine Schnittansicht einer Bedienvorrichtung mit mehreren Bedienabschnitten gemäß einem noch weiteren Ausführungsbeispiel der Erfindung; und
- Fig. 7: eine stark vereinfachte Darstellung des Funktionsprinzips einer Bedienvorrichtung gemäß einer zweiten Ausführungsvariante der Erfindung.

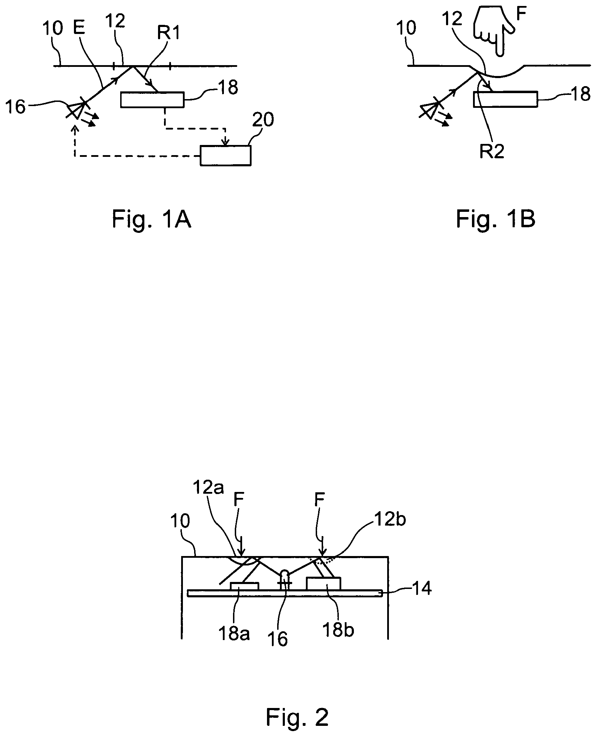

Anhand von Fig. 1 soll zunächst die grundsätzliche Funktionsweise einer Bedienvorrichtung gemäß einer ersten Ausführungsvariante näher erläutert werden. Dabei ist in dem Teilbild von Fig. 1A der Zustand ohne Betätigung durch den Benutzer dargestellt, während in dem Teilbild von Fig. 1B der Zustand bei Betätigung durch den Benutzer dargestellt ist.

Die Bedienvorrichtung weist eine Abdeckplatte 10 zum Beispiel in Form einer Bedienblende zum Beispiel eines elektronischen Haushaltsgerätes auf. Diese Abdeckplatte 10 hat eine einem Benutzer zugewandte Benutzerseite 10a (oben in Fig. 1), welche der Außenseite der Bedienblende bzw. des Gerätes entspricht, und eine einem Benutzer abgewandte Rückseite 10b (unten in Fig. 1), welche der Innenseite der Bedienblende bzw. des Gerätes entspricht. Die Abdeckplatte 10 ist beispielsweise aus Kunststoff oder Metall gefertigt.

Diese Abdeckplatte 10 weist wenigstens einen Bedienabschnitt 12 auf, der für den Benutzer ein Bedienelement definiert, das der Benutzer betätigen kann. Der Bedienabschnitt 12 ist in die Abdeckplatte 12 integriert bzw. einteilig mit dieser ausgebildet oder als separate Komponente in diese eingesetzt und wahlweise mit dieser verbunden. Wie in Vergleich der Teilbilder von Fig. 1A und 1B zeigt, ist der Bedienabschnitt 12 durch eine Krafteinwirkung F von der Benutzerseite 10a her, zum Beispiel mit einem Finger des Benutzers, elastisch verformbar ausgestaltet. D.h. nach Beendigung der Krafteinwirkung F kehrt der Bedienabschnitt 12 wieder in seinen Ausgangszustand zurück, der in Teilbild von Fig. 1A angedeutet ist.

Der Bedienabschnitt 12 ist vorzugsweise für den Benutzer gekennzeichnet, damit dieser ihn leichter auffinden und seine Funktionalität identifizieren kann. Hierzu können der Bedienabschnitt 12 oder seine Außenseite selbst gekennzeichnet sein oder kann die Abdeckplatte 10 in der Nähe des Bedienabschnitts 12 gekennzeichnet sein. Die Kennzeichnung erfolgt zum Beispiel optisch durch Farben und/oder Symbole, haptisch durch Oberflächenstrukturen, elektrisch durch eine Hinterleuchtung oder Signallampen, oder dergleichen.

Die Bedienvorrichtung weist ferner wenigstens einen Sender 16 zum Beispiel in Form einer LED und wenigstens einen Empfänger 18 zum Beispiel in Form eines CCD-Chips auf. Der Sender 16 emittiert elektromagnetische Strahlung, vorzugsweise Licht im sichtbaren oder Infrarot-Wellenlängenbereich, und der Empfänger 18 erfasst elektromagnetische Strahlung desselben Wellenlängenbereichs. Dabei ist der wenigstens eine Empfänger 18 ausgestaltet, um Strahlung ortsaufgelöst zu erfassen. Dies bedeutet, dass ein einzelner Empfänger über eine solche Fähigkeit verfügt (z.B. CCD-Chip, Sensor-Array, etc.) oder mehrere Empfänger (z.B. Photodioden, Phototransistoren, etc.) nebeneinander angeordnet sind und gemeinsam ausgewertet werden.

Der wenigstens eine Sender 16 und der wenigstens eine Empfänger 18 sind mit einer Steuerelektronik 20 verbunden. Die Steuerelektronik 20 weist zum Beispiel einen Mikrocontroller auf bzw. ist aus einem solchen gebildet. Die Steuerelektronik 20 steuert den wenigstens einen Sender 16 an, d.h. schaltet diesen im einfachsten Fall nur an und aus oder betreibt diesen zum Beispiel getaktet. Außerdem wertet die Steuerelektronik 20 die von dem wenigstens einen Empfänger 18 erzeugten Messsignale aus, um eine Betätigung des Bedienabschnitts 12 durch einen Benutzer detektieren zu können.

Wie in den Teilbildern von Fig. 1A und 1B veranschaulicht, trifft die vom Sender 16 emittierte Strahlung (E) auf den Bedienabschnitt 12 bzw. seine Rückseite und wird dort reflektiert. Die am Bedienabschnitt 12 reflektierte Strahlung R1, R2 trifft dann auf den Empfänger 18 und wird von diesem erfasst, der entsprechende Messsignale erzeugt, die von der Steuerelektronik 20 ausgewertet werden. Im Ausgangszustand von Teilbild 1A, d.h. ohne Betätigung des Bedienabschnitts 12 durch den Benutzer, befindet sich der Bedienabschnitt 12 in seinem unverformten Ausgangszustand und reflektiert die Strahlung R1 zum Empfänger 18. Im Betätigungszustand von Teilbild 1B, d.h. bei einer Krafteinwirkung F durch den Benutzer auf den Bedienabschnitt 12, ist der Bedienabschnitt 12 verformt und reflektiert die Strahlung R2 zum Empfänger 18. Ein Vergleich der beiden Teilbilder von Fig. 1A und 1B zeigt, dass selbst bei einer relativ geringen Verformung des Bedienabschnitts 12 eine sehr deutliche Veränderung im Erfassungsort der reflektierten Strahlung R2 erfolgt. Diese relative Veränderung des Erfassungsortes wird vom ortsauflösenden Empfänger 18 erfasst, sodass die Steuerelektronik 20 eine Betätigung des Bedienabschnitts 12 erfassen kann.

Für die Auswertung durch die Steuerelektronik 20 genügt die Erfassung einer relativen Veränderung des Erfassungsortes am Empfänger 18. Absolute Messwerte für die Veränderung sind nicht erforderlich, können in einzelnen Ausführungsformen aber ebenso erfasst und ausgewertet werden. Die Erfassung nur der relativen Veränderung vermindert auch die Anforderungen an die Maß- und Positionsgenauigkeiten der einzelnen Komponenten bzw. vergrößert die erlaubten Toleranzbereiche in der Fertigung und bei der Montage dieser Komponenten.

Fig. 2 zeigt ein erstes Ausführungsbeispiel einer erfindungsgemäßen Bedienvorrichtung, die nach dem oben erläuterten Grundprinzip von Fig. 1 funktioniert.

Wie in Fig. 2 angedeutet, sind die Sender 16 und die Empfänger 18 auf einer Trägerplatte 14 zum Beispiel in Form einer Leiterplatte angeordnet. Die Trägerplatte 14 ist beispielsweise im Wesentlichen parallel zur Abdeckplatte 10 und mit einem Abstand hinter dieser angeordnet. Die Steuerelektronik 20 kann ebenfalls auf dieser Trägerplatte 14 angeordnet sein.

In diesem Ausführungsbeispiel weist die Bedienvorrichtung zwei Bedienelemente auf, d.h. ist die Abdeckplatte 10 mit zwei Bedienabschnitten 12a, 12b ausgestattet. Für beide Bedienabschnitte 12a, 12b ist ein gemeinsamer Sender 16 vorgesehen, der Strahlung in Richtung zu beiden Bedienabschnitten 12a, 12b emittiert. Andererseits ist für jeden der zwei Bedienabschnitte 12a, 12b wenigstens ein (eigener) Empfänger 18a, 18b vorgesehen.

In Abwandlung des in Fig. 2 dargestellten Ausführungsbeispiels können natürlich auch mehr als zwei Bedienabschnitte 12a, 12b in der Abdeckplatte 10 vorgesehen sein, die von einem gemeinsamen Sender 16 angestrahlt werden.

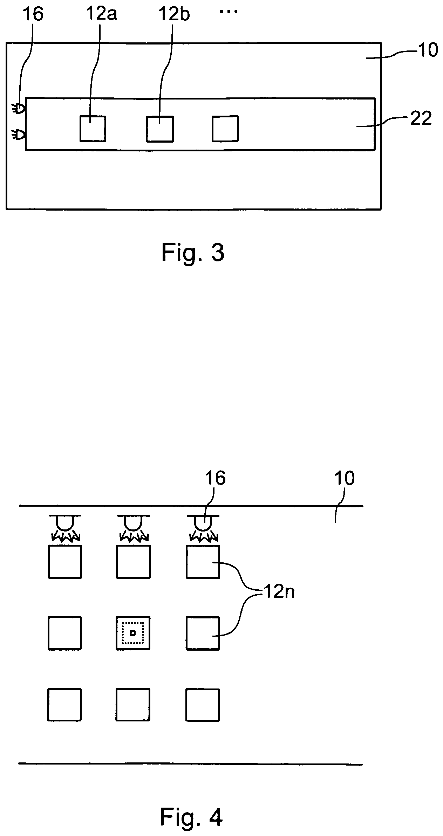

Fig. 3 zeigt ein zweites Ausführungsbeispiel einer erfindungsgemäßen Bedienvorrichtung, die nach dem obigen Grundprinzip funktioniert.

In diesem Ausführungsbeispiel ist der wenigstens eine Sender 16 entfernt von den mehreren Bedienabschnitten 12a, 12b, ... der Abdeckplatte 10 angeordnet. Um die von dem wenigstens einen Sender 16 emittierte Strahlung zu den einzelnen Bedienabschnitten 12a, 12b, ... zu transportieren ist ein Lichtleiter 22 geeigneter Form und Größe vorgesehen.

Die von dem wenigstens einen Sender 16 in den Lichtleiter 22 eingekoppelte Strahlung kann beispielsweise im Bereich der Bedienabschnitte 12a, 12b, ... aus dem Lichtleiter 22 ausgekoppelt werden. Die an den Bedienabschnitten 12 reflektierten Strahlungen können dann über einen oder mehrere Empfänger 18 erfasst werden. Die Veränderung des Erfassungsortes bei einer Betätigung der Bedienabschnitte 12a, 12b, ... erfolgt zum Beispiel in einer Richtung quer zur Längserstreckung des Lichtleiters 22, sodass der oder die Empfänger 18a, 18b, ... in der Draufsicht von Fig. 2 neben dem Lichtleiter 22 positioniert werden können.

Fig. 4 zeigt ein drittes Ausführungsbeispiel einer erfindungsgemäßen Bedienvorrichtung, die nach dem obigen Grundprinzip funktioniert.

In diesem Ausführungsbeispiel weist die Abdeckplatte 10 ein Feld von n Bedienabschnitten 12a, ... 12n auf, die beispielsweise matrixartig (vgl. Fig. 4) oder entlang einer Linie angeordnet sind. In Fig. 4 ist für jede Reihe (allgemeiner Untergruppe) von Bedienabschnitten 12n wenigstens ein Sender 16 vorgesehen. Die mehreren Sender 16 für die verschiedenen Reihen oder Untergruppen von Bedienabschnitten 12n können von der Steuerelektronik 20 wahlweise auch getaktet betrieben werden.

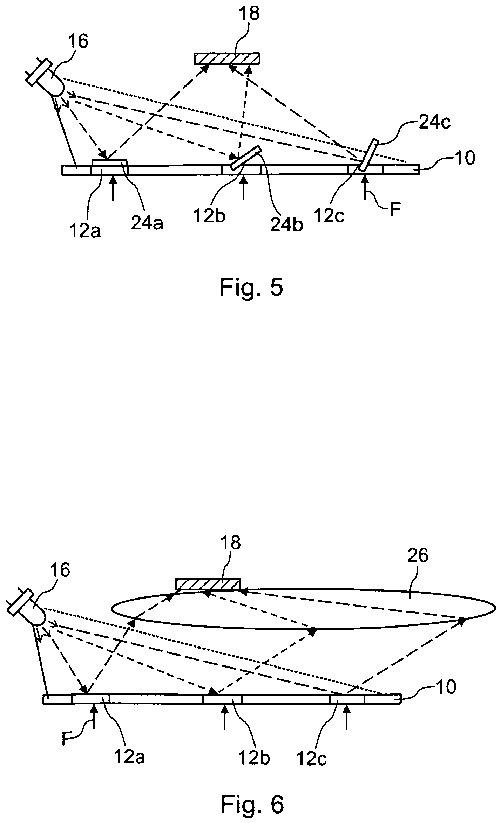

Nachfolgend werden anhand der Fig. 5 und 6 weitere Ausführungsbeispiele beschrieben, bei denen die Anzahlen der Sender und Empfänger trotz mehrerer Bedienabschnitte 12n möglichst klein gehalten werden können.

In dem Ausführungsbeispiel von Fig. 5 ist an den Rückseiten der mehreren Bedienabschnitte 12a, 12b, ... jeweils ein Reflektor 24a, 24b, ... angeordnet. Die Reflektoren 24a, 24b, ... der verschiedenen Bedienabschnitte 12a, 12b, ... werden von einem gemeinsamen Sender 16 angestrahlt.

Die Reflektoren 24a, 24b, ... der verschiedenen Bedienabschnitte 12a, 12b, ... sind unterschiedlich zueinander ausgestaltet und/oder ausgerichtet, sodass sie unterschiedliche Reflexionswinkel besitzen. Als Resultat werden die vom Sender 16 emittierte Strahlung an den Reflektoren 24a, 24b, ... trotz deren beabstandeter Positionen auf eine Gruppe ortsauflösender Empfänger 18 reflektiert. Dabei wandern die reflektierten Strahlungen für die verschiedenen Bedienabschnitte 12a, 12b, ... über unterschiedliche Empfängers 18, welche von der Steuerelektronik 20 getaktet angesteuert bzw. ausgewertet werden, sodass die Betätigungen der verschiedenen Bedienabschnitte 12a, 12b, ... voneinander differenziert werden können.

In dem Ausführungsbeispiel von Fig. 6 ist im Strahlengang zwischen den mehreren Bedienabschnitten 12a, 12b, ... und der Empfängergruppe 18 eine Linse 26 angeordnet. Diese Linse 26 ist derart ausgestaltet und angeordnet, dass die von den verschiedenen Bedienabschnitten 12a, 12b, ... reflektierten Strahlungen unterschiedlich abgelenkt werden. Als Resultat werden die von den Bedienabschnitten 12a, 12b, ... reflektierten Strahlungen trotz deren beabstandeter Positionen an der Abdeckplatte 10 mit Hilfe der Linse 26 auf die Empfängergruppe 18 fokussiert. Dabei wandern die von den verschiedenen Bedienabschnitten 12a, 12b, ... reflektierten Strahlungen über unterschiedliche Empfänger 18 der Empfängergruppe, welche von der Steuerelektronik 20 getaktet angesteuert bzw. ausgewertet werden, sodass die Betätigungen der verschiedenen Bedienabschnitte 12a, 12b, ... voneinander differenziert werden können.

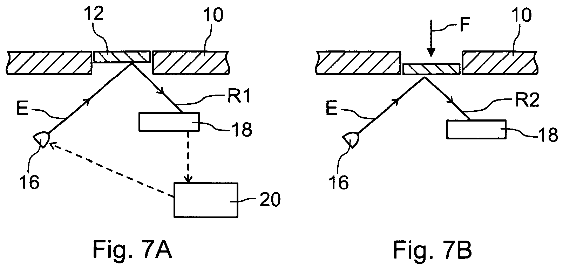

Anhand von Fig. 7 soll nun die grundsätzliche Funktionsweise einer Bedienvorrichtung gemäß einer zweiten Ausführungsvariante näher erläutert werden. Dabei ist in dem Teilbild von Fig. 7A der Zustand ohne Betätigung durch den Benutzer dargestellt, während in dem Teilbild von Fig. 7B der Zustand bei Betätigung durch den Benutzer dargestellt ist.

In Fig. 7 sind die gleichen bzw. entsprechenden Komponenten mit den gleichen Bezugsziffern gekennzeichnet wie in Fig. 1 bis 6. Auch können die oben beschriebenen Ausführungsbeispiele der Fig. 2 bis 6 vom Fachmann problemlos auf die Ausführungsvariante der Fig. 7 übertragen werden.

Die zweite Ausführungsvariante von Fig. 7 unterscheidet sich von der ersten Ausführungsvariante von Fig. 1 durch die Ausgestaltung des Bedienabschnitts 12 in der Abdeckplatte 10. Während der Bedienabschnitt 12 in Fig. 1 durch eine Krafteinwirkung F durch einen Benutzer elastisch verformbar ausgestaltet ist, ist der Bedienabschnitt der Ausführungsvariante von Fig. 7 durch eine Krafteinwirkung F durch einen Benutzer bewegbar.

Zu diesem Zweck ist der Bedienabschnitt 12 bevorzugt als eine von der Abdeckplatte 10 separate Komponente gefertigt und beweglich in einer Durchbrechung in der Abdeckplatte 10 gelagert. Bei einer Betätigung des Bedienabschnitts 12 wird dieser in die Abdeckplatte 10 hineingedrückt und nach innen verschoben, wie im Teilbild von Fig. 7B veranschaulicht. Nach Beendigung der Krafteinwirkung F kehrt der Bedienabschnitt 12 wieder in seine Ausgangsposition zurück, der in Teilbild von Fig. 7A angedeutet ist. Dies geschieht um Beispiel mit Hilfe eines elastischen Federelements, welches den Bedienabschnitt in seine Ausgangsposition vorspannt.

Wie in den Teilbildern von Fig. 7A und 7B veranschaulicht, trifft die vom Sender 16 emittierte Strahlung (E) auf den Bedienabschnitt 12 bzw. seine Rückseite und wird dort reflektiert. Die am Bedienabschnitt 12 reflektierte Strahlung R1, R2 trifft dann auf den Empfänger 18 und wird von diesem erfasst, der entsprechende Messsignale erzeugt, die von der Steuerelektronik 20 ausgewertet werden. Im Ausgangszustand von Teilbild 7A, d.h. ohne Betätigung des Bedienabschnitts 12 durch den Benutzer, befindet sich der Bedienabschnitt 12 in seiner Ausgangsposition und reflektiert die Strahlung R1 zum Empfänger 18. Bei einer Krafteinwirkung F durch den Benutzer auf den Bedienabschnitt 12 ist der Bedienabschnitt 12 nach innen geschoben und reflektiert die Strahlung R2 zum Empfänger 18. Ein Vergleich der beiden Teilbilder von Fig. 7A und 7B zeigt, dass selbst bei einem relativ geringen Bewegungshub des Bedienabschnitts 12 eine sehr deutliche Veränderung im Erfassungsort der reflektierten Strahlung R2 erfolgt. Diese relative Veränderung des Erfassungsortes wird vom ortsauflösenden Empfänger 18 erfasst, sodass die Steuerelektronik 20 eine Betätigung des Bedienabschnitts 12 erfassen kann.

Optional kann die Rückseite des Bedienabschnitts 12 auch von der planen Gestalt abweichen, um den Effekt der Veränderung des Erfassungsortes zu verstärken.

Im Übrigen entspricht die zweite Ausführungsvariante von Fig. 7 der oben anhand von Fig. 1 beschriebenen ersten Ausführungsvariante.

Ferner können die beiden Ausführungsvarianten von Fig. 1 und 7 miteinander kombiniert werden. Der Bedienabschnitt 12 wird dann bei einer Krafteinwirkung durch einen Benutzer sowohl leicht verformt als auch etwas bewegt.

### BEZUGSZIFFERNLISTE

- 10: Abdeckplatte, z.B. Bedienblende
- 10a: Benutzerseite
- 10b: Rückseite
- 12: Bedienabschnitt
- 12n: Bedienabschnitte
- 14: Trägerplatte, z.B. Leiterplatte
- 16: Sender
- 18: Empfänger
- 18n: Empfänger
- 20: Steuerelektronik
- 22: Lichtleiter
- 24n: Reflektoren
- 26: Linse

- E: emittierter Strahl
- F: Druckkraft
- R1: reflektierter Strahl, ohne Tastenbetätigung
- R2: reflektierter Strahl, bei Tastenbetätigung

## Patentansprüche

1. Bedienvorrichtung, insbesondere für ein elektronisches Haushaltsgerät, aufweisend:
eine Abdeckplatte (10) mit einer einem Benutzer zugewandten Benutzerseite (10a), wobei die Abdeckplatte (10) mehrere Bedienabschnitte (12n) zum Definieren mehrerer Bedienelemente aufweist, wobei die mehreren Bedienabschnitte (12n) jeweils derart ausgestaltet sind, dass sie durch eine Krafteinwirkung (F) von der Benutzerseite (10a) der Abdeckplatte (10) her zumindest teilweise elastisch verformbar und/oder bewegbar sind;
wenigstens einen Sender (16, 16n) zum Emittieren von elektromagnetischer Strahlung (E) und wenigstens einen Empfänger (18, 18n) zum Erfassen von elektromagnetischer Strahlung (R1, R2), wobei die Bedienabschnitte (12n) jeweils derart ausgestaltet sind, dass sie die von dem wenigstens einen Sender (16, 16n) emittierte Strahlung (E) zumindest teilweise reflektieren, und der wenigstens eine Empfänger (18, 18n) derart angeordnet und/oder ausgestaltet ist, dass er eine ortsaufgelöste Erfassung der von den Bedienabschnitten (12n) reflektierten Strahlung (R1, R2) ermöglicht; und
eine Steuerelektronik (20) zum Auswerten von von dem wenigstens einen Empfänger (18, 18n) erzeugten Messsignalen, die in Abhängigkeit von einem Erfassungsort der reflektierten Strahlung (R1, R2) eine Betätigung der Bedienabschnitte (12n) detektiert,
**dadurch gekennzeichnet, dass**
für mehrere der mehreren Bedienabschnitte (12n) ein gemeinsamer Sender (16) und jeweils ein eigener Empfänger (18n) vorgesehen sind oder ein gemeinsamer Empfänger (18) und jeweils ein eigener Sender (16n) vorgesehen sind, wobei die mehreren eigenen Empfänger (18n) oder die mehreren eigenen Sender (16n), die verschiedenen Bedienabschnitten (12n) zugeordnet sind, von der Steuerelektronik (20) getaktet betrieben werden, um die Betätigungen der verschiedenen Bedienabschnitte (12n) voneinander zu differenzieren.

2. Bedienvorrichtung nach Anspruch 1,
**dadurch gekennzeichnet, dass**
die Bedienabschnitte (12n) für die von dem wenigstens einen Sender (16, 16n) emittierte Strahlung (E) im Wesentlichen undurchlässig ausgestaltet sind.

3. Bedienvorrichtung nach einem der vorhergehenden Ansprüche,
**dadurch gekennzeichnet, dass**
wenigstens ein Lichtleiter (22) vorgesehen ist, um die von dem wenigstens einen Sender (16, 16n) emittierte Strahlung (E) zu einem der mehreren Bedienabschnitte (12n) oder zu mehreren der mehreren Bedienabschnitte (12n) zu transportieren.

4. Bedienvorrichtung nach einem der vorhergehenden Ansprüche,
**dadurch gekennzeichnet, dass**
mehrere der mehreren Bedienabschnitte (12n) wenigstens einen Reflektor (24n) zum Reflektieren der von dem wenigstens einen Sender (16, 16n) emittierten Strahlung (E) aufweisen, wobei die verschiedenen Bedienabschnitten (12n) zugeordneten Reflektoren (24n) unterschiedliche Reflexionswinkel haben.

5. Bedienvorrichtung nach einem der vorhergehenden Ansprüche,
**dadurch gekennzeichnet, dass**
wenigstens eine Linse (26) angeordnet ist, die mehreren der mehreren Bedienabschnitte (12n) gemeinsam zugeordnet ist und die von verschiedenen Bedienabschnitten (12n) reflektierten Strahlungen unterschiedlich ablenkt.

6. Elektronisches Haushaltsgerät mit wenigstens einer Bedienvorrichtung nach einem der vorhergehenden Ansprüche.

## Claims

1. Operating device, in particular for an electronic household appliance, comprising:
a cover plate (10) with a user-facing user side (10a), the cover plate (10) having a plurality of operating portions (12n) for defining a plurality of operating elements, the plurality of operating portions (12n) each being designed so that they are at least partially elastically deformable and/or movable by way of an action of force (F) from the user side (10a) of the cover plate (10) ;
at least one transmitter (16, 16n) for emitting electromagnetic radiation (E) and at least one receiver (18, 18n) for detecting electromagnetic radiation (R1, R2), with each operating portion (12n) being designed so that it at least partially reflects the radiation (E) emitted by the at least one transmitter (16, 16n), and the at least one receiver (18, 18n) is arranged and/or designed so that it enables a spatially resolved detection of the radiation (R1, R2) reflected by the operating portions (12n); and
control electronics (20) for evaluating measurement signals produced by the at least one receiver (18, 18n), the control electronics detecting an actuation of the operating portions (12n) on the basis of a detection location of the reflected radiation (R1, R2),
**characterized in that**
a joint transmitter (16) and a respective dedicated receiver (18n) or a joint receiver (18) and a respective dedicated transmitter (16n) are provided for a plurality of the plurality of operating portions (12n), with the plurality of dedicated receivers (18n) or the plurality of dedicated transmitters (16n) assigned to different operating portions (12n) being operated in clocked fashion by the control electronics (20) in order to differentiate the actuations of the various operating portions (12n) from one another.

2. Operating device according to Claim 1,
**characterized in that**
the operating portions (12n) are designed to be substantially opaque to the radiation (E) emitted by the at least one transmitter (16, 16n).

3. Operating device according to either of the preceding claims,
**characterized in that**
at least one optical waveguide (22) is provided in order to transport the radiation (E) emitted by the at least one transmitter (16, 16n) to one of the plurality of operating portions (12n) or to a plurality of the plurality of operating portions (12n).

4. Operating device according to any one of the preceding claims,
**characterized in that**
a plurality of the plurality of operating portions (12n) have at least one reflector (24n) for reflecting the radiation (E) emitted by the at least one transmitter (16, 16n), with the reflectors (24n) assigned to different operating portions (12n) having different reflection angles.

5. Operating device according to any one of the preceding claims,
**characterized in that**
at least one lens (26) is arranged, the said lens being jointly assigned to a plurality of the plurality of operating portions (12n) and deflecting the radiations reflected by different operating portions (12n) differently.

6. Electronic household appliance having at least one operating device according to any one of the preceding claims.

## Revendications

1. Dispositif de commande, en particulier pour un appareil ménager électronique, présentant :
une plaque de recouvrement (10) pourvue d'une face utilisateur orientée vers un utilisateur (10a), la plaque de recouvrement (10) présentant plusieurs parties de commande (12n) pour définir plusieurs éléments de commande, les plusieurs parties de commande (12n) étant respectivement configurées de façon à pouvoir être au moins partiellement déformées élastiquement et/ou déplacées par l'action d'une force (F) provenant de la face utilisateur (10a) de la plaque de recouvrement (10) ;
au moins un émetteur (16, 16n) servant à émettre un rayonnement électromagnétique (E), et au moins un récepteur (18, 18n) servant à recevoir un rayonnement électromagnétique (R1, R2), dans lequel les parties de commande (12n) sont respectivement configurées de telle sorte qu'elles réfléchissent au moins partiellement le rayonnement (E) émis par ledit au moins un émetteur (16, 16n), et ledit au moins un récepteur (18, 18n) est disposé et/ou configuré de telle sorte qu'il permet une détection à résolution spatiale du rayonnement (R1, R2) réfléchi par les parties de commande (12n) ; et
une électronique de commande (20) servant à évaluer des signaux de mesure générés par ledit au moins un récepteur (18, 18n) et qui détecte en fonction d'un emplacement de détection du rayonnement réfléchi (R1, R2) un actionnement des parties de commande (12n),
**caractérisé en ce que** pour plusieurs des plusieurs parties de commande (12n), un émetteur commun (16) et respectivement un récepteur spécifique (18n) sont prévus, ou un récepteur commun (18) et respectivement un émetteur spécifique (16n) sont prévus, dans lequel les plusieurs récepteurs spécifiques (18n) ou les plusieurs émetteurs spécifiques (16n), qui sont associés à différentes parties de commande (12n), sont exploités par l'unité de commande (20) de manière cadencée afin de différencier les actionnements des différentes parties de commande (12n).

2. Dispositif de commande selon la revendication 1, **caractérisé en ce que** les parties de commande (12n) sont configurées de manière substantiellement opaque au rayonnement (E) émis par ledit au moins un émetteur (16, 16n).

3. Dispositif de commande selon l'une quelconque des revendications précédentes, **caractérisé en ce qu'**au moins un guide d'ondes optiques (22) est prévu pour transporter le rayonnement (E) émis par ledit au moins un émetteur (16, 16n) jusqu'à l'une des plusieurs parties de commande (12n) ou à plusieurs des plusieurs parties de commande (12n).

4. Dispositif de commande selon l'une quelconque des revendications précédentes, **caractérisé en ce que** plusieurs des plusieurs parties de commande (12n) présentent au moins un réflecteur (24n) servant à réfléchir le rayonnement (E) émis par ledit au moins un émetteur (16, 16n), dans lequel les réflecteurs (24n) associés à différentes parties de commande (12n) présentent des angles de réflexion différents.

5. Dispositif de commande selon l'une quelconque des revendications précédentes, **caractérisé en ce qu'**au moins une lentille (26) est disposée qui est associée en commun à plusieurs des plusieurs parties de commande (12n) et qui dévie différemment des rayonnements réfléchis par différentes parties de commande (12n).

6. Appareil ménager électronique, comprenant au moins un dispositif de commande selon l'une quelconque des revendications précédentes.
